# EUROPÄISCHE PATENTSCHRIFT

(11) **EP 2 590 789 B1**
(45) Veröffentlichungstag und Bekanntmachung des Hinweises auf die Patenterteilung: **01.07.2015**
(21) Anmeldenummer: 11721555.8
(22) Anmeldetag: 27.05.2011
(51) Int. Cl.: B28D 5/00

(54) **TRÄGERVORRICHTUNG UND VERFAHREN ZUM SCHNEIDEN EINES AN DER TRÄGERVORRICHTUNG BEFESTIGTEN MATERIALBLOCKS**
CARRIER DEVICE AND METHOD FOR CUTTING A MATERIAL BLOCK FIXED TO THE CARRIER DEVICE
DISPOSITIF SUPPORT ET PROCÉDÉ DE COUPE D'UN BLOC DE MATÉRIAU

(30) Priorität: 10.11.2010 DE 102010050897; 20.08.2010 DE 102010034945; 09.07.2010 DE 102010026631
(43) Veröffentlichungstag der Anmeldung: 15.05.2013
(73) Patentinhaber: INTERPANE Entwicklungs-und Beratungsgesellschaft mbH, 37697 Lauenförde (DE)
(72) Erfinder: MICHEL, Lars, 37671 Höxter (DE); KAPPERTZ, Oliver, 33098 Paderborn (DE); HERLITZE, Lothar, 37691 Derental (DE)
(74) Vertreter: Körfer, Thomas
(86) Internationale Anmeldenummer: PCT/EP2011/058719
(87) Internationale Veröffentlichungsnummer: WO 2012/004052

(56) Entgegenhaltungen:
- EP-A1- 2 111 960
- DE-A1-102004 058 194
- JP-A- 9 207 126

## Beschreibung

Die Erfindung betrifft eine Trägervorrichtung zur Befestigung eines Materialblocks in einer Schneidevorrichtung beim Schneiden von Wafern gemäß dem Oberbegriff des Anspruchs 1 sowie ein Verfahren zum Schneiden und Trennen von Wafern aus einem mit der Trägervorrichtung verbundenen Materialblocks gemäß dem Oberbegriff des Anspruchs 12 Eine solche Trägervorrichtung und ein solches Verfahren sind der EP 2 111 960 A1 zu entnehmen.

Zur Herstellung insbesondere von Solarzellen werden sehr dünne Scheiben, sogenannte Wafer, aus einem Materialblock aus kristallinem Silizium geschnitten. Der Silizium-Materialblock wird als Silizium-Ingot bezeichnet und liegt meist in Quader- oder Zylinderform vor. Ein Silizium-Ingot wird durch Sägen insbesondere mittels einer Drahtsäge zu einzelnen Wafern zerteilt. Typische Draht- bzw. Sägeblattdicken liegen bei 100 bis 300 µm. Aus einem Quader mit 125mm Seitenlänge entstehen somit ca. 175 bis 400 Wafer einer Stärke von 200 bis 400 µm. Um ein Anhaften der einzelnen Wafer untereinander nach dem Sägeschritt zu verhindern, wird der gesägte Materialblock mit einem Spülmedium gespült um das noch vorhandene Slurry aus dem Sägeschlitzen zu entfernen.

Die DE 10 2008 045 990 A1 beschreibt eine Vorrichtung und ein Verfahren zum Schneiden von Wafern aus einem Materialblock. Um die Wafer möglichst schadfrei schneiden und handhaben zu können, wird der Materialblock an einem Träger, beispielsweise an einer Glasplatte, angeklebt. Die Glasplatte ist wiederum mit einem metallenen Maschinenträger verbunden. Dieser Verbund wird mit dem nach unten hängenden Materialblock in eine Sägevorrichtung eingeführt. Das Drahtfeld der Sägevorrichtung wird mit einem Sägeschlamm, auch Säge-Slurry genannt, beaufschlagt. Beim Schneiden bleiben ein Teil des Materialabtrags sowie ein Teil des Sägeschlamms an den Wafern haften. Dieser wird durch eine Spülvorrichtung ausgewaschen. Dazu wird Spülmedium durch eine Spritzdüse, die in einem oberen Bereich der Seitenfläche des Materialblocks aufgesetzt ist, in die Sägeschlitze eingespritzt. Das Spülmedium dringt in die Sägeschlitze zwischen den Wafern ein und fließt zusammen mit dem Abrieb und dem Sägeschlamm, etc. entlang der Wafer aus den Sägeschlitzen heraus.

Das in der DE 10 2008 045 990 A1 beschriebene Verfahren und die beschriebene Vorrichtung haben den Nachteil, dass der Sägeschlitz zwischen den Wafern nicht gleichmäßig von Spülmedium benetzt wird. Das Spülmedium verbleibt hauptsächlich im Randbereich der Wafer. Nur wenig Spülmedium dringt bis in den Zentralbereich der Wafer vor. Durch eine Erhöhung des Sprühdruckes kann ein tieferes Eindringen des Spülmediums in die Sägeschlitze erreicht werden. Dies ist aber mit einer höheren mechanischen Belastung der Wafer selbst und insbesondere deren Oberflächen verbunden und führt zu einem erhöhten Ausschuss.

Aus der EP 2 111 960 A1 ist eine Trägervorrichtung zur Befestigung eines Materialblocks in einer Schneidevorrichtung zum Schneiden von Wafern in einer anderen Ausgestaltung bekannt.

Es ist somit die Aufgabe der vorliegenden Erfindung eine Trägervorrichtung zur Befestigung eines Materialblocks beim Schneiden zu Wafer sowie ein Verfahren zum Schneiden von Wafern zu beschreiben, bei dem die Wafer vollständig und mit geringer mechanischer Belastung voneinander getrennt werden können. Die entsprechende Vorrichtung und das Verfahren sollen dabei möglichst kostengünstig und einfach herstell- bzw. durchführbar sein.

Die Aufgabe wird durch die erfindungsgemäße Trägervorrichtung gemäß Anspruch 1 sowie dem erfindungsgemäßen Verfahren entsprechend Anspruch 12 gelöst. In den Unteransprüchen sind vorteilhafte Weiterbildungen der erfindungsgemäßen Trägervorrichtung und des Verfahrens dargestellt.

Die erfindungsgemäße Trägervorrichtung zur Befestigung eines Materialblocks in einer Schneidevorrichtung beim Schneiden zu Wafern wird der Materialblock auf einer Oberfläche der Trägervorrichtung verrutschsicher fixiert, wobei eine Mehrzahl von Langlöchern senkrecht zur Schneideebene der Schneidevorrichtung und verteilt über die Breite der Trägervorrichtung in die Trägervorrichtung eingebracht sind und Spülkanäle bilden.

Durch das Einschneiden der Schneidevorrichtung in die Langlöcher sind bevorzugt Spülöffnungen ausgebildet.

Durch diese Spülkanäle kann das Spülmedium über die Spülöffnungen verteilt über die gesamte Breite der Wafer, in die Sägeschlitze eingebracht werden. Somit kann eine gleichmäßige Verteilung von Spülmedium über die gesamte Breite des Wafers sowie in alle Sägeschlitze des Materialblocks sichergestellt werden. Das Spülmedium muss lediglich mit geringem Druck über die Spülöffnungen eingebracht werden und reduziert somit die mechanische Belastung der einzelnen Wafer und ihrer Oberflächen.

Erfindungsgemäß besteht die Trägervorrichtung aus mindestens zwei Trägerelementen.

Der Aufbau der Trägervorrichtung aus mindestens zwei Trägerelementen hat den Vorteil, dass die Trägerelemente nach dem Schneiden des Materialblocks zu Wafern wieder voneinander getrennt werden können und das oder die Trägerelemente, die nicht eingesägt sind, für das Schneiden eines weiteren Materialblocks verwendet werden können. Ein Großteil der Trägervorrichtung kann somit wiederverwendet und somit kann die Herstellungskosten der Wafer reduziert werden.

Vorteilhafterweise besteht das erste Trägerelement aus Glas, insbesondere aus Kalk-Natron-Glas. Dieses wird als Flachglas gefertigt, wobei das Profil in einfacher weise durch Fräsen, Schleifen, Lasern und/oder Bohren eingebracht ist. Das erste Trägerelement ist somit in großer Stückzahl kostengünstig herstellbar und jederzeit verfügbar. Dies erlaubt eine geringe Lagerhaltung und dementsprechend wenig Kosten.

Es ist ebenfalls vorteilhaft, dass die mindestens zwei Trägerelemente durch Kleben miteinander verbunden sind. Durch den Einsatz von entsprechenden Lösungsmitteln können nicht nur die Wafer vom ersten Trägerelement getrennt, sondern gleichzeitig die Trägerelemente voneinander gelöst werden.

Die Aufgabe wird ebenfalls in vorteilhafter Weise durch das erfindungsgemäße Verfahren gelöst. Dabei ist ein Materialblock auf einer erfindungsgemäßen Trägervorrichtung befestigt und wird in einer Schneidevorrichtung geschnitten. Dabei schneidet die Schneidevorrichtung bis in die Spülkanäle der Trägervorrichtung ein und erzeugt dabei Spülöffnungen. Danach wird Spülmedium in die Spülkanäle der Trägervorrichtung eingebracht, das durch die Spülöffnungen zu den Wafern geführt wird.

Dieses Verfahren erlaubt eine einfache Spülung der Sägeschlitze zwischen den einzelnen Wafern über die gesamte Breite der Wafer hinweg. Da die Spülöffnungen durch das Einschneiden der Schneidevorrichtung in die Trägervorrichtung erzeugt werden, sind die Spülöffnungen jeweils genau in den Spalten zwischen den Wafern platziert. Somit kann bei unterschiedlich dicken Wafern immer die gleiche Trägervorrichtung verwendet werden. Es wird somit lediglich eine Trägervorrichtung benötigt, die in einer großen Stückzahl günstig hergestellt bzw. in großer Stückzahl erworben werden.

Da die Spülkanäle in ihrer Längsausdehnung vollständig von der Trägervorrichtung umschlossen und vor dem Schneiden keine Spülöffnungen vorhanden sind, können die Spülkanäle beim Befestigen des Materialblocks an der Trägervorrichtung nicht, z.B. durch Klebemittel, verunreinigt werden. Somit ist eine zuverlässige Verteilung von Spülmittel über die gesamte Länge des Spülkanals sichergestellt.

Ausführungsbeispiele der erfindungsgemäßen Trägervorrichtung sowie des Verfahrens zum Schneiden und Ablösen von Wafern aus einem Materialblock sind in der Zeichnung beispielhaft dargestellt und werden anhand der folgenden Beschreibung näher erläutert. Es zeigen:
- Fig. 1: ein Beispiel einer nicht erfindungsgemäßen Trägervorrichtung in perspektivischer Ansicht;
- Fig. 2: ein Ausführungsbeispiel einer erfindungsgemäßes Trägervorrichtung verbunden mit einem Materialblock in perspektivischer Ansicht;
- Fig. 3: ein Ausführungsbeispiel eines erfindungsgemäßen ersten Trägerelementes in perspektivischer Ansicht und
- Fig. 4: eine Draufsicht auf die profilierte Oberfläche des in Fig. 3 gezeigten ersten Trägerelements.

Einander entsprechende Teile sind in allen Figuren mit den gleichen Bezugszeichen versehen.

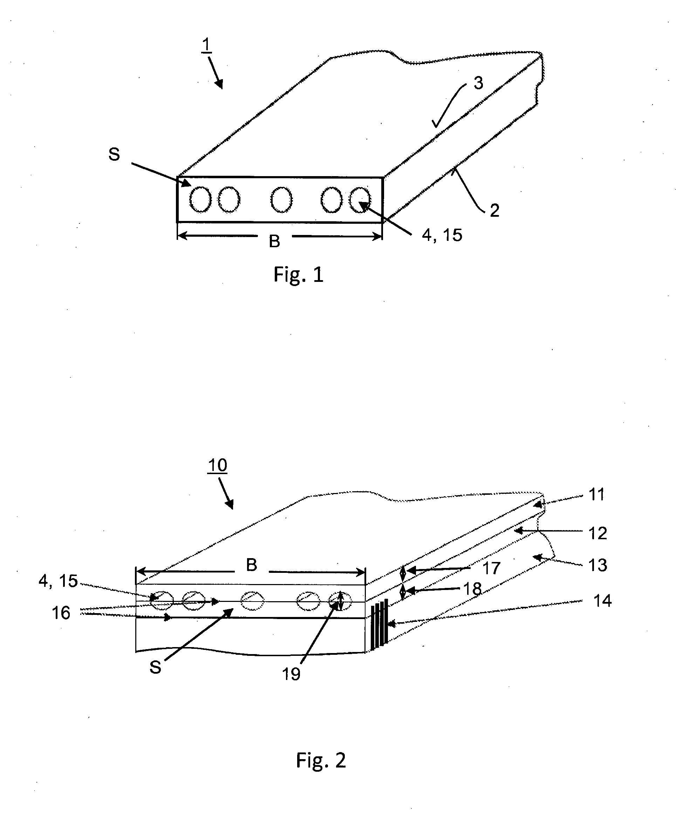

Fig. 1 zeigt eine einteilige Trägervorrichtung 1 mit einer Mehrzahl von Langlöchern 4. Diese sind senkrecht zur Schneidebene S und verteilt über die Breite B der Trägervorrichtung in diese eingebracht und bilden Spülkanäle 15 aus. Auf eine erste Oberfläche 2 wird ein nicht dargestellter Materialblock fest aufgebracht, in den meisten Fällen aufgeklebt. Die zweite Oberfläche 3 der Trägervorrichtung 1 wird mit einer Maschinenhalterung verbunden, z. B. ebenfalls auf diese Maschinenhalterung aufgeklebt und in die Schneidevorrichtung eingespannt. Die Trägervorrichtung 1 kann je nach Material, aus dem sie hergestellt ist, auch direkt in die Schneidemaschine eingespannt werden. Ein oder mehrere Schneidedrähte werden an der der Oberfläche 2 gegenüberliegenden Oberfläche des Materialblocks angesetzt. Als Schneidhilfsmittel wird zum Beispiel Siliziumcarbit (SiC) hinzugefügt. Als Kühl- und Trennmittel wird z. B. Polyethylenglycol (PEG) oder Öl verwendet. Die z. B. ca. 100µm bis 300µm dicken Sägedrähte bzw. Sägeblätter werden so durch den Materialblock in Richtung der Trägervorrichtung 1 bewegt.

Um sicherzustellen, dass der Materialblock komplett durchschnitten ist, schneidet man üblicherweise in die Trägervorrichtung 1 hinein. In der vorliegenden Erfindung wird dieses Einschneiden in die Trägervorrichtung 1 ausgenutzt, um Spülöffnungen in die Langlöcher 4 bzw. Spülkanäle 15 einzubringen. Nach dem Schneiden wird der gesägte Materialblock mit einem Spülmedium gespült, um den vorhandenen Schleifstaub und die sonstigen Hilfsmittel aus den Sägeschlitzen zu entfernen und die Wafer voneinander zu trennen. Dazu werden röhrenförmige Spülfinger in die Langlöcher 4 eingebracht, die ein Spülmedium über die gesamte Länge der Langlöcher 4 hinweg abgeben. Das Spülmedium wird durch die entstandenen Spülöffnungen in die Sägeschlitze zwischen den Wafern weitergegeben bzw. unter Druck eingesprüht und spült den Sägeschlitz sowie die Oberfläche der Wafer frei.

Fig. 2 zeigt eine zweiteilige Trägervorrichtung 10, an der ein Materialblock 13 befestigt ist. Der Materialblock 13 wird mit einem Klebemittel, das in eine Klebefuge 16 eingebracht ist, mit einem ersten Trägerelement 12 verklebt. Bei runden Materialblöcken wird zumindest eine Seite abgesägt, so dass eine flache Oberfläche entsteht, die mit dem ersten Trägerelement 12 verbunden wird. Ein zweites Trägerelement 11, das beispielsweise aus rostfreiem Stahl besteht, wird ebenfalls mit dem ersten Trägerelement, z. B. durch Klebemittel wie ZweiKomponentenkleber, das in eine weitere Klebenut 16 zwischen dem ersten und zweiten Trägerelement eingebracht ist, bewegungsfrei verbunden.

Wie im Fall der einteiligen Trägervorrichtung 1, sind auch in der zweiteiligen Trägervorrichtung 10 Langlöcher 4, die als Spülkanäle 15 dienen, senkrecht zur Schneiderichtung S in der Trägervorrichtung 10 ausgebildet. Dazu ist in jeweils einer Oberfläche der beiden Trägerelemente 11, 12 ein Profil ausgeformt. Dieses Profil besteht aus einer Mehrzahl von Nuten, die in etwa senkrecht zur Schneideebene S des Materialblocks 13 ausgerichtet sind. Die Nuten sind mit gleichem oder auch unterschiedlichem Abstand voneinander über die Breite B der beiden Trägerelemente 11, 12 verteilt. Die zwei Trägerelemente 11, 12 weisen ein jeweils gegengleich ausgeformtes Profil auf und sind an diesen profilierten Oberfläche miteinander verbunden.

Bevorzugterweise besteht das erste Trägerelement 12 aus Glas, insbesondere aus Kalk-Natron-Glas, mit einer Stärke 18 zwischen 7 mm und 15 mm, in besonders bevorzugter Weise von 12 mm. Das zweite Trägerelement 11 ist bevorzugterweise aus einem metallischen Material, z. B. rostfreiem Stahl oder Messing gefertigt und weist eine Stärke 17 von z. B. 10 bis 25 mm, bevorzugt von 12 bis 20 mm auf. Die Weite 19 eines Spülkanals 15 beträgt vorzugsweise 10 bis 15 mm, insbesondere 12 mm.

Beim Schneiden der Wafer wird der Sägedraht bzw. das Schneidblatt nicht nur durch den Materialblock 13 hindurchgeführt, sondern schneidet in das erste Trägerelement ein, so dass die entstandenen Sägeschlitze 14 bis an die profilierte Oberfläche 20 des ersten Trägerelements 12 hineinreichen. Wie bei der einteiligen Trägervorrichtung 1 werden Spülfinger in die Spülkanäle 15 eingeführt, die Spülmedium abgeben. Das Spülmedium wird über die entstandenen Spülöffnungen in die entstandenen Sägeschlitze 14 zwischen den Wafern abgegeben. Die Wafer werden nach dem Schneiden von der Trägervorrichtung 10 abgelöst. Ebenso werden das erste und das zweite Trägerelement voneinander getrennt. Das erste Trägerelement 12 wird der Entsorgung zugeführt, das zweite Trägerelement 11 wird wiederverwendet. Zum Schneiden eines weiteren Materialblocks wird lediglich ein neues erstes Trägerelement 12 mit dem zweiten Trägerelement 11 verbunden.

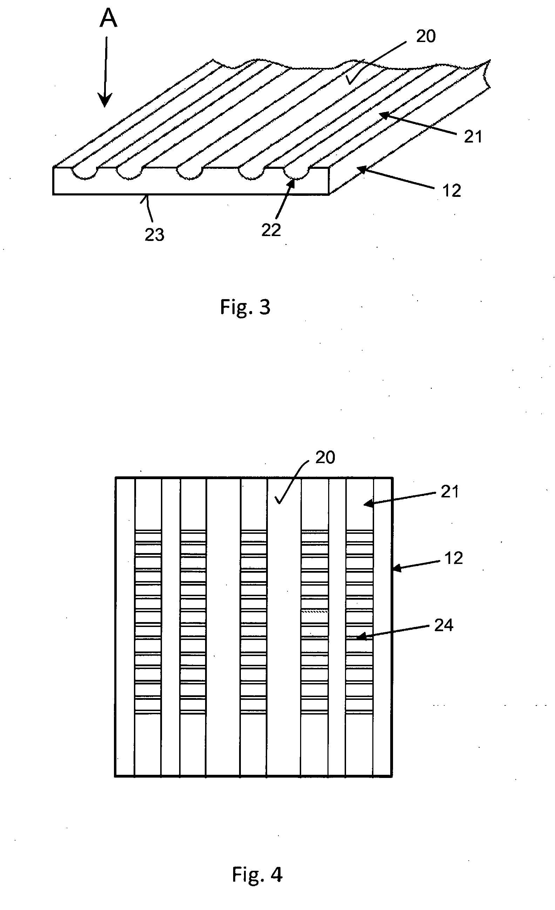

Fig. 3 zeigt ein erstes Trägerelement 12. Es weist eine nicht-profilierte Oberfläche 23 auf, die mit dem Materialblock, nicht dargestellt, verbunden wird. Dieser nicht-profilierten Oberfläche 23 liegt eine profilierte Oberfläche 20 gegenüber, in die Nuten 21 senkrecht zur Sägeebene S eingebracht sind. Diese Nuten werden üblicherweise durch Fräsen bzw. in einem Oberflächen-Schleifprozess eingebracht. Die in Fig. 3 dargestellten Nuten haben eine runde Nutkontur 22. Andere Konturformen 22, z. B. eckig, sind ebenfalls möglich und können an das verwendete Spülsystem, insbesondere an die Form der verwendeten Spülfinger angepasst werden.

Fig. 4 zeigt eine Draufsicht auf das in Fig. 3 abgebildete erste Trägerelement in Blickrichtung des Pfeils A. Die profilierte Oberfläche 20 weist in den Nuten 21 schlitzförmige Spülöffnungen 24 auf, deren Weite längs der Nut der Dicke des Sägedrahtes bzw. des Schneidblattes entspricht. Die Breite einer Spülöffnung 24 wird durch die Einschnitt-Tiefe und die Kontur der Nut bestimmt. Durch eine runde Nutkontur und unterschiedliche Einschnitt-Tiefe kann die Breite der Spülöffnung variiert werden, bei einer viereckigen Nutkontur bleibt die Breite der Spülöffnung bei jeder Einschnitt-Tiefe konstant. Durch eine entsprechende Wahl der Nutkontur können somit unterschiedliche Spülöffnungsbreiten eingestellt werden.

Alle beschriebenen und/oder bezeichneten Merkmale können im Rahmen der Erfindung vorteilhaft miteinander kombiniert werden. Die Erfindung ist nicht auf die Ausführungsbeispiele beschränkt.

## Patentansprüche

1. Trägervorrichtung zur Befestigung eines Materialblocks (13) in einer Schneidevorrichtung beim Schneiden zu Wafern, wobei die Trägervorrichtung so ausgebildet ist, dass der Materialblock (13) auf einer Oberfläche (2) der Trägervorrichtung verrutschsicher fixierbar ist und die Durchgangsrichtung von durchgehenden Langlöcher (4) senkrecht zur Ebene von eingebrachten Sägeschlitzen (14) ausgerichtet sind und dass die Langlöcher (14) verteilt über die Breite (B) in die Trägervorrichtung (1, 10) eingebracht sind und Spülkanäle (15) bilden, wobei die Trägervorrichtung (1,10) aus mindestens zwei Trägerelementen (11, 12) besteht,
**dadurch gekennzeichnet,**
**dass** zwei Trägerelemente (11,12) jeweils eine gegengleich profilierte Oberfläche (20) aufweisen, die zwei Trägerelemente (11,12) an den jeweils profilierten Oberflächen (20) miteinander verbunden sind und die Spülkanäle (15) ausbilden.

2. Trägervorrichtung nach Anspruch 1,
**dadurch gekennzeichnet,**
**dass** das erste Trägerelement (12) aus einem amorphen Material besteht.

3. Trägervorrichtung nach Anspruch 1,
**dadurch gekennzeichnet,**
**dass** das erste Trägerelement (12) aus Glas, insbesondere aus Kalk-Natron Glas, besteht.

4. Trägervorrichtung nach Anspruch 1,
**dadurch gekennzeichnet,**
**dass** das zweite Trägerelement (11) aus einem anorganischen, bevorzugt aus einem metallischen Material besteht.

5. Trägervorrichtung nach Anspruch 1,
**dadurch gekennzeichnet,**
**dass** das erste Trägerelement (12) aus Glas und das zweite Trägerelement (11) aus einem metallischen Material sind.

6. Trägervorrichtung nach Anspruch 1 und 5,
**dadurch gekennzeichnet,**
**dass** durch die Sägeschlitze (14) in den Langlöchern (4) Spülöffnungen (24) ausgebildet sind.

7. Trägervorrichtung nach einem der Ansprüche 1 bis 6,
**dadurch gekennzeichnet,**
**dass** jeweils mindestens eine Oberfläche (20) eines Trägerelements (11, 12) ein unebenes Profil aufweist.

8. Trägervorrichtung nach einem der Ansprüche 1 bis 7,
**dadurch gekennzeichnet,**
**dass** das Profil eines Trägerelements (11, 12) aus einer Mehrzahl von Nuten (21) besteht, die in etwa senkrecht zur Ebene der eingebrachten Sägeschlitze (14) ausgerichtet sind.

9. Trägervorrichtung nach einem der Ansprüche 1 bis 8,
**dadurch gekennzeichnet,**
**dass** das Profil des ersten Trägerelements (12) durch Fräsen, Schleifen, Lasern und/oder Bohren eingebracht ist.

10. Trägervorrichtung nach einem der Ansprüche 1 bis 9,
**dadurch gekennzeichnet,**
**dass** das zweite Trägerelement (11) mit der Schneidevorrichtung verbindbar ist.

11. Trägervorrichtung nach einem der Ansprüche 1 bis 10,
**dadurch gekennzeichnet,**
**dass** die zwei Trägerelemente (11, 12) miteinander durch Kleben verbunden sind.

12. Verfahren zum Schneiden und Ablösen von Wafern aus einem Materialblock (13),
wobei der Materialblock (13) auf einer Trägervorrichtung (1, 10) befestigt wird, die so ausgebildet ist, dass der Materialblock (13) auf einer Oberfläche (2) der Trägervorrichtung verrutschsicher fixierbar ist und durchgehende Langlöcher (4) verteilt über die Breite (B) in die Trägervorrichtung (1, 10) eingebracht sind und Spülkanäle (15) bilden, wobei die Trägervorrichtung (1,10) aus mindestens zwei Trägerelementen (11, 12) besteht,
wobei der Materialblock an einem ersten Trägerelement (12) fixiert ist, wobei der Materialblock (13) in einer Schneidevorrichtung geschnitten wird, wobei die Schneidevorrichtung bis in Spülkanäle (15) der Trägervorrichtung (1, 10) einschneidet und Spülöffnungen (24) erzeugt und
wobei Spülmedium in die Spülkanäle (15) der Trägervorrichtung (1, 10) eingebracht wird, das durch die Spülöffnungen (24) zu den Wafer geführt wird,
**dadurch gekennzeichnet,**
**dass** die zwei Trägerelemente (11,12) jeweils eine gegengleich profilierte Oberfläche (20) aufweisen, wobei die zwei Trägerelemente (11,12) an den jeweils profilierten Oberflächen (20) miteinander verbunden sind und die Spülkanäle (15) ausbilden und
**dass** die Schneidevorrichtung bis in die profilierte Oberfläche (20) des ersten Trägerelements (12) einschneidet.

13. Verfahren nach Anspruch 12,
**dadurch gekennzeichnet,**
**dass** nach dem Schneiden das erste Trägerelement (12) von der Trägervorrichtung (10) gelöst wird und durch ein unbenutztes anderes Trägerelement ersetzt wird.

## Claims

1. Carrier device for fastening a material block (13) in a cutting device while it is being cut into wafers, wherein the carrier device is configured such that the material block (13) is fixable in a non-slip manner on a surface (2) of the carrier device and the passage direction of through-slots (4) is oriented perpendicularly to the plane of introduced saw cuts (14) and such that the slots (4) are introduced into the carrier device (1, 10) across the width (B) and form rinsing ducts (15), wherein the carrier device (1, 10) consists of at least two carrier elements (11, 12),
**characterized**
**in that** two carrier elements (11, 12) each have a surface (20) that is profiled in a mirror-inverted manner, and the two carrier elements (11, 12) are connected together at the respectively profiled surfaces (20) and form the rinsing ducts (15).

2. Carrier device according to Claim 1,
**characterized**
**in that** the first carrier element (12) consists of an amorphous material.

3. Carrier device according to Claim 1,
**characterized**
**in that** the first carrier element (12) consists of glass, in particular of soda-lime glass.

4. Carrier device according to Claim 1,
**characterized**
**in that** the second carrier element (11) consists of an inorganic material, preferably of a metal material.

5. Carrier device according to Claim 1,
**characterized**
**in that** the first carrier element (12) is made of glass and the second carrier element (11) is made of a metal material.

6. Carrier device according to Claim 1 and 5,
**characterized**
**in that** rinsing openings (24) are formed by the saw cuts (14) in the slots (4).

7. Carrier device according to one of Claims 1 to 6,
**characterized**
**in that** in each case at least one surface (20) of a carrier element (11, 12) has an uneven profile.

8. Carrier device according to one of Claims 1 to 7,
**characterized**
**in that** the profile of one carrier element (11, 12) consists of a plurality of grooves (21) which are oriented approximately perpendicularly to the plane of the introduced saw cuts (14).

9. Carrier device according to one of Claims 1 to 8,
**characterized**
**in that** the profile of the first carrier element (12) is introduced by milling, grinding, laser-cutting and/or drilling.

10. Carrier device according to one of Claims 1 to 9,
**characterized**
**in that** the second carrier element (11) is connectable to the cutting device.

11. Carrier device according to one of Claims 1 to 10,
**characterized**
**in that** the two carrier elements (11, 12) are connected together by adhesive bonding.

12. Method for cutting and detaching wafers from a material block (13),
wherein the material block (13) is fastened to a carrier device (1, 10) which is configured such that the material block (13) is fixable in a non-slip manner on a surface (2) of the carrier device and through-slots (4) are introduced into the carrier device (1, 10) in a manner distributed across the width (B) and form rinsing ducts (15), wherein the carrier device (1, 10) consists of at least two carrier elements (11, 12), wherein the material block is fixed to a first carrier element (12), wherein the material block (13) is cut in a cutting device, wherein the cutting device cuts into rinsing ducts (15) of the carrier device (1, 10) and creates rinsing openings (24), and
wherein rinsing medium is introduced into the rinsing ducts (15) of the carrier device (1, 10), said rinsing medium being guided through the rinsing openings (24) to the wafers
**characterized**
**in that** the two carrier elements (11, 12) each have a surface (20) that is profiled in a mirror-inverted manner, wherein the two carrier elements (11, 12) are connected together at the respectively profiled surfaces (20) and form the rinsing ducts (15), and
**in that** the cutting device cuts into the profiled surface (20) of the first carrier element (12).

13. Method according to Claim 12,
**characterized**
**in that**, after cutting, the first carrier element (12) is detached from the carrier device (10) and is replaced by an unused other carrier element.

## Revendications

1. Dispositif de support pour la fixation d'un bloc de matériau (13) dans un dispositif de coupe lors de la coupe en tranches ou wafers,
le dispositif de support étant réalisé de façon telle que le bloc de matériau (13) puisse être fixé sans risque de glissement sur une surface (2) du dispositif de support et la direction de traversée de trous longitudinaux continus (4) traversants soit perpendiculaire au plan de fentes ou traits de sciage (14) ayant été pratiqués, et de façon telle que les trous longitudinaux (14) soient réalisés dans le dispositif de support (1, 10) de manière répartie sur la largeur (B) de celui-ci et forment des canaux de rinçage (15), et
le dispositif de support (1, 10) étant constitué d'au moins deux éléments de support (11, 12),
**caractérisé**
**en ce que** deux éléments de support (11, 12) présentent respectivement une surface (20) profilée de manière identique et diamétralement opposée, et les deux éléments de support (11, 12) sont reliés ou assemblés mutuellement au niveau des surfaces profilées (20) respectives, et forment les canaux de rinçage (15).

2. Dispositif de support selon la revendication 1,
**caractérisé**
**en ce que** le premier élément de support (12) est réalisé en un matériau amorphe.

3. Dispositif de support selon la revendication 1,
**caractérisé**
**en ce que** le premier élément de support (12) est réalisé en verre, notamment en un verre sodocalcique.

4. Dispositif de support selon la revendication 1,
**caractérisé**
**en ce que** le deuxième élément de support (11) est réalisé en un matériau inorganique, de préférence un matériau métallique.

5. Dispositif de support selon la revendication 1,
**caractérisé**
**en ce que** le premier élément de support (12) est en verre et le deuxième élément de support (11) est en un matériau métallique.

6. Dispositif de support selon les revendications 1 et 5,
**caractérisé**
**en ce que** les fentes ou traits de sciage (14) produisent des ouvertures de rinçage (24) dans les trous longitudinaux (4).

7. Dispositif de support selon l'une des revendications 1 à 6,
**caractérisé**
**en ce que** respectivement au moins une surface (20) d'un élément de support (11, 12) présente un profil non plat.

8. Dispositif de support selon l'une des revendications 1 à 7,
**caractérisé**
**en ce que** le profil d'un élément de support (11, 12) est constitué par une pluralité de rainures (21), qui sont orientées environ perpendiculairement au plan des fentes ou traits de sciage (14) ayant été pratiqués.

9. Dispositif de support selon l'une des revendications 1 à 8,
**caractérisé**
**en ce que** le profil du premier élément de support (12) est produit par fraisage, meulage, usinage au laser et/ou perçage.

10. Dispositif de support selon l'une des revendications 1 à 9,
**caractérisé**
**en ce que** le deuxième élément de support (11) peut être relié au dispositif de coupe.

11. Dispositif de support selon l'une des revendications 1 à 10,
**caractérisé**
**en ce que** les deux éléments de support (11, 12) sont reliés mutuellement par collage.

12. Procédé destiné à couper et détacher des tranches ou wafers à partir d'un bloc de matériau (13),
d'après lequel on fixe le bloc de matériau (13) sur un dispositif de support (1, 10), qui est réalisé de façon telle que le bloc de matériau (13) puisse être fixé sans risque de glissement sur une surface (2) du dispositif de support et que des trous longitudinaux (4) soient réalisés dans le dispositif de support (1, 10) de manière répartie sur la largeur (B) de celui-ci et forment des canaux de rinçage (15),
d'après lequel le dispositif de support (1, 10) est constitué d'au moins deux éléments de support (11, 12), d'après lequel le bloc de matériau est fixé à un premier élément de support (12),
d'après lequel le bloc de matériau (13) est coupé dans un dispositif de coupe,
d'après lequel le dispositif de coupe incise jusque dans des canaux de rinçage (15) du dispositif de support (1, 10) et réalise des ouvertures de rinçage (24), et d'après lequel on fait pénétrer dans les canaux de rinçage (15) du dispositif de support (1, 10), un agent de rinçage, qui est ensuite mené, à travers les ouvertures de rinçage (24), jusqu'aux tranches ou wafers,
**caractérisé**
**en ce que** les deux éléments de support (11, 12) présentent respectivement une surface (20) profilée de manière identique et diamétralement opposée, les deux éléments de support (11, 12) étant reliés ou assemblés mutuellement au niveau des surfaces profilées (20) respectives et forment les canaux de rinçage (15), et
**en ce que** le dispositif de coupe incise jusque dans la surface profilée (20) du premier élément de support (12).

13. Procédé selon la revendication 12,
**caractérisé**
**en ce qu'**après la coupe, le premier élément de support (12) est détaché du dispositif de support (10) et est remplacé par un autre élément de support non encore utilisé.
